(19) Europäisches Patentamt / European Patent Office / Office européen des brevets

(11) **EP 4 262 337 A1**

(12) **EUROPEAN PATENT APPLICATION**

(43) Date of publication:
**18.10.2023 Bulletin 2023/42**

(21) Application number: **23165480.7**

(22) Date of filing: **30.03.2023**

(51) International Patent Classification (IPC):
**H10K 59/126** (2023.01)    **H01L 29/786** (2006.01)

(52) Cooperative Patent Classification (CPC):
**H10K 59/126; H01L 29/78672**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.04.2022 KR 20220047164**

(71) Applicant: **LG Display Co., Ltd.**
**Seoul 07336 (KR)**

(72) Inventors:
• **KANG, Min-Gu**
**10845 Paju-si, Gyeonggi-do (KR)**
• **CHOI, SeungChan**
**10845 Paju-si, Gyeonggi-do (KR)**
• **KO, Younghyun**
**10845 Paju-si, Gyeonggi-do (KR)**
• **CHOI, Uyhyun**
**10845 Paju-si, Gyeonggi-do (KR)**
• **JANG, Jaeman**
**10845 Paju-si, Gyeonggi-do (KR)**

(74) Representative: **Viering, Jentschura & Partner mbB**
**Patent- und Rechtsanwälte**
**Am Brauhaus 8**
**01099 Dresden (DE)**

(54) **ORGANIC LIGHT EMITTING DISPLAY DEVICE**

(57) An organic light emitting display device (100) is disclosed that uses a hybrid type thin film transistor. The organic light emitting display device includes a conductive pattern (415, 475) with a higher etch resistance compared to an inorganic thin film in an upper edge of a semiconductor pattern, and is thereby capable of simplifying a manufacturing process of a substrate (401) on which an array of hybrid type thin film transistors each including multiple layers is disposed, and improving the performance of thin film transistors formed on the array substrate (401). The organic light emitting display device (100) can represent a variety of grayscale images at low grayscales as a driving thin film transistor including an oxide semiconductor pattern is designed to have an increased s-factor value.

*FIG.5*

EP 4 262 337 A1

**Description**

**CROSS-REFERENCE TO RELATED APPLICATION**

This application claims the priority benefit of Republic of Korea Patent Application No. 10-2022-0047164, filed on April 15, 2022 in the Korean Intellectual Property Office.

**BACKGROUND**

**Technical Field**

The present disclosure relates to display devices including a hybrid type of thin film transistor, and in particular, to organic light emitting display devices capable of solving a problem that a semiconductor pattern located under the thin film transistor is overetched during a manufacturing process, and including a conductive pattern instead of a doped region. In particular, the present disclosure relates to organic light emitting display devices capable of representing a wide range of grayscale images and realizing fast on-off operation by adjusting the S-factor of at least one specific thin film transistor among a plurality of thin film transistors.

**Description of the Related Art**

Recently, with the development of multimedia, flat-panel display devices have increasingly become important. To meet demands for a variety of display devices, flat-panel display devices such as a liquid crystal display device, a plasma display device, an organic light emitting display device, and the like have been developed and commercialized. The organic light emitting display device has advantages over other flat-panel display devices, such as faster response speed, higher luminous efficiency, wider viewing angle, and the like, and thus, is becoming increasingly popular.

In such an organic light emitting display device, a plurality of pixels may be arranged in a matrix pattern. Each pixel may include a light emitting element part represented by an organic emission layer and a pixel circuit part represented by at least one thin film transistor. The pixel circuit part may include a plurality of thin film transistors (TFT) such as a driving TFT for supplying a driving current to operate an organic light emitting element and a switching TFT for supplying a gate signal to the driving TFT, and the like.

Further, a gate driver for providing a gate signal to a pixel may be disposed in a non-display area of the organic light emitting display device.

**SUMMARY**

As described above, since a plurality of thin film transistors disposed in the pixel circuit part of a pixel, for example, a subpixel, and the gate driver can perform different functions, therefore, electrical characteristics thereof may be required to be different from one another. In order for a plurality of thin film transistors disposed in a pixel to have different electrical characteristics, for example, the plurality of thin film transistors may be configured to have different structures or include different semiconductor materials. In this example, layers including these semiconductor materials may be needed to be formed in different layers, and may be exposed in different etching conditions in an etching process, and thereby, one or more semiconductor materials included in one or more relatively lower layers among the semiconductor materials may be over etched.

One or more example embodiments of the present disclosure may provide an organic light emitting display device having a structure in which a doping process is not performed for forming a source region and a drain region, and in addition, the performance of thin film transistors included in a pixel can be stably provided, while preventing or at least reducing the over-etching of a semiconductor pattern located in one or more relatively lower layers in each pixel. In an aspect of the present disclosure, an organic light emitting display device according to claim 1 is provided. Further embodiments are described in the dependent claims.

According to one embodiment of the present disclosure an organic light emitting display device comprises: a substrate including a display area and a non-display area located outside of the display area; a first thin film transistor on the substrate, the first thin film transistor comprising a first semiconductor pattern, a first gate electrode, a first source electrode, and a first drain electrode; a second thin film transistor on the substrate, the second thin film transistor comprising a second semiconductor pattern, a second gate electrode, a second source electrode, and a second drain electrode; a conductive pattern on an upper surface of at least one of the first semiconductor pattern or the second semiconductor pattern; and a first light shield pattern overlapping the second semiconductor pattern, the first light shield pattern connected to the second source electrode, wherein the first semiconductor pattern comprises a polycrystalline semiconductor pattern and the second semiconductor pattern comprises an oxide semiconductor pattern.

In one embodiment, an organic light emitting display device comprises: a substrate on which a display area and a non-display area located outside of the display area are disposed; a first thin film transistor disposed in the display area, and comprising a first semiconductor pattern comprising a first conductive pattern, a first gate electrode, a first source electrode, and a first drain electrode; a second thin film transistor disposed in the display area, and comprising a second semiconductor pattern comprising a second conductive pattern, a second gate electrode, and a second source electrode, and a second drain electrode; a first light shield pattern located under, and overlapping, the first semiconductor pattern such that the first light shield pattern is closer to the substrate than the first semiconductor pattern; and a second light shield pattern overlapping the second semiconductor pattern, wherein a vertical distance between the first semiconductor pattern and the first light shield pattern is less than a vertical distance between the second semiconductor pattern and the second light shield pattern.

In one embodiment, a light emitting display device comprises: a substrate including a display area and a non-display area around the display area; a first thin film transistor in the display area, the first thin film transistor including a first drain electrode, a first source electrode, a first gate electrode, and a first semiconductor pattern having a first channel region, a first source region at a first end of the first channel region, and a first drain region at a second end of the first channel region that is opposite the first end; a first conductive pattern on the first semiconductor pattern, the first conductive pattern including a first conductive portion that is in contact with and overlaps an upper surface of the first source region and a second conductive portion that is in contact with and overlaps an upper surface of the first drain region; and a light emitting element configured to emit light, the light emitting element connected to the first thin film transistor.

In the organic light emitting display device according to one or more example embodiments of the present disclosure, since the process of doping source and drain regions can be omitted, one or more gate, source and drain electrodes of one or more transistors can be disposed in or on a same layer, and the number of masks or number of times that one or more masks are used can be therefore reduced.

## BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain principles of the disclosure. In the drawings:

FIG. 1A illustrates an example organic light emitting display device according to one embodiment of the present disclosure;

FIG. 1B is an example cross-sectional view of the display device taken along line "G-G'" in FIG. 1 according to one embodiment of the present disclosure;

FIG. 2 illustrates an example subpixel of the organic light emitting display device according to one embodiment of the present disclosure;

FIG. 3 is an example circuit diagram of the subpixel of the organic light emitting display device according to one embodiment of the present disclosure;

FIG. 4A is an example cross-sectional view of a thin film transistor disposed in a gate driver in a non-display area, and a driving thin film transistor and a switching thin film transistor disposed in a display area, of the organic light emitting display device according to one embodiment of the present disclosure;

FIG. 4B is an example cross-sectional view of a bending area that is a part of the non-display area of the organic light emitting display device according to one embodiment of the present disclosure;

FIG. 5 is another example cross-sectional view of a thin film transistor disposed in a gate driver in the non-display area, and a driving thin film transistor and a switching thin film transistor disposed in the display area, of the organic light emitting display device according to one embodiment of the present disclosure;

FIG. 6 is a another example cross-sectional view of a thin film transistor disposed in a gate driver in the non-display area, and a driving thin film transistor and a switching thin film transistor disposed in the display area, of the organic light emitting display device according to one embodiment of the present disclosure; and

FIG. 7 is another example cross-sectional view of a thin film transistor disposed in a gate driver in the non-display area, and a driving thin film transistor and a switching thin film transistor disposed in the display area, of the organic light emitting display device according to one embodiment of the present disclosure.

## DETAILED DESCRIPTION

Reference will now be made in detail to embodiments of the present disclosure, examples of which may be illustrated in the accompanying drawings.

Advantages and features of the present disclosure, and implementation methods thereof will be clarified through following example embodiments described with reference to the accompanying drawings. In the following description, the structures, embodiments, implementations, methods and operations described herein are not limited to the specific example set forth herein and may be changed as is known in the art, unless otherwise specified.

The present disclosure may be embodied in different forms and should not be construed as limited to the example embodiments set forth herein. Rather, these example embodiments are provided so that this disclosure may be sufficiently thorough and complete to assist those skilled in the art to fully understand the scope of the present disclosure. Further, the protected scope of the present disclosure is defined by claims and their equivalents.

The shapes, sizes, ratios, angles, numbers, and the like, which are illustrated in the drawings to describe various example embodiments of the present disclosure, are merely given by way of example. Therefore, the present disclosure is not limited to the illustrations in the drawings. Like reference numerals designate like elements throughout, unless otherwise specified. Names of the respective elements used in the following explanations are selected only for convenience of writing the specification and may thus be different from those used in actual products. In the following description, where the detailed description of the relevant known function or configuration may unnecessarily obscure aspects of the present disclosure, a detailed description of such known function or configuration may be omitted. Where the terms "comprise," "have," "include," "contain," "constitute," "make up of," "formed of," and the like are used, one or more other elements may be added unless the term, such as "only," is used. An element described in the singular form is intended to include a plurality of elements, and vice versa, unless the context clearly indicates otherwise. Singular forms used herein are intended to include plural forms unless the context clearly indicates otherwise.

In construing an element, the element is to be construed as including an error or tolerance range even where no explicit description of such an error or tolerance range is provided. Further, the term "may" fully encompasses all the meanings of the term "can."

Where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used. For example, where an element or layer is disposed "on" another element or layer, a third element or layer may be interposed therebetween. Furthermore, the terms "left," "right," "top," "bottom, "downward," "upward," "upper," "lower," and the like refer to an arbitrary frame of reference.

In describing a temporal relationship, when the temporal order is described as, for example, "after," "subsequent," "next," or "before," a case which is not continuous may be included unless a more limiting term, such as "just," "immediate(ly)," or "direct(ly)," is used. The term "at least one" could be understood as including any or all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

Although the terms "first," "second," A, B, (a), (b), and the like may be used herein to describe various elements, these elements should not be interpreted to be limited by these terms as they are not used to define a particular order or precedence. These terms are used only to distinguish one element from another. For example, a first element could be termed a second element, and, similarly, a second element could be termed a first element, without departing from the scope of the present disclosure.

The expression of a first element, a second elements "and/or" a third element could be understood as one of the first, second and third elements or as any or all combinations of the first, second and third elements. By way of example, A, B and/or C can refer to only A, only B, or only C; any or some combination of A, B, and C; or all of A, B, and C.

For the expression that an element or layer is "connected," "coupled," or "adhered" to another element or layer, the element or layer can not only be directly connected, coupled, or adhered to another element or layer, but also be indirectly connected, coupled, or adhered to another element or layer with one or more intervening elements or layers "disposed" or "interposed" between the elements or layers, unless otherwise specified. For the expression that an element or layer "contacts," "overlaps," or the like with another element or layer, the element or layer can not only directly contact, overlap, or the like with another element or layer, but also indirectly contact, overlap, or the like with another element or layer with one or more intervening elements or layers "disposed" or "interposed" between the elements or layers, unless otherwise specified.

--A first embodiment--

Hereinafter, examples and embodiments according to aspects of the present disclosure will be described in detail with reference to the accompanying drawings. In addition, for convenience of description, a scale in which each of elements is illustrated in the accompanying drawings may differ from an actual scale. Thus, the illustrated elements are not limited to the specific scale in which they are illustrated in the drawings.

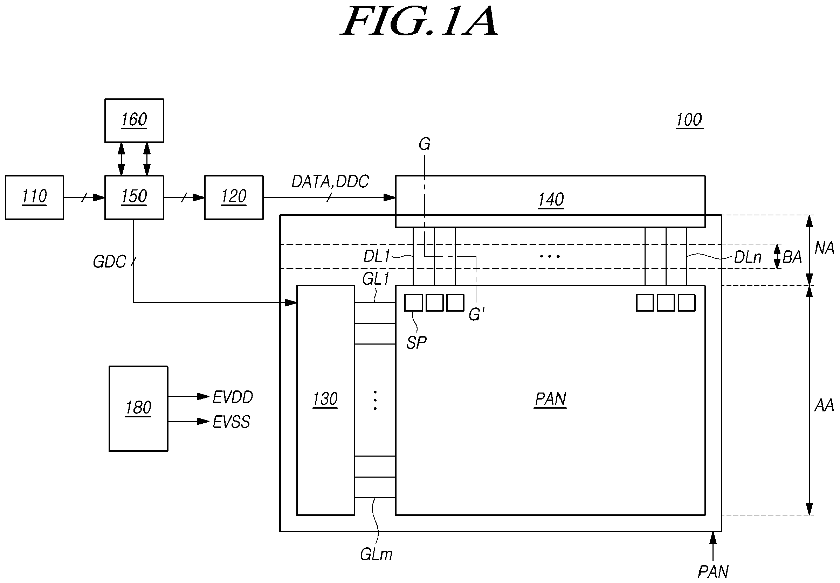

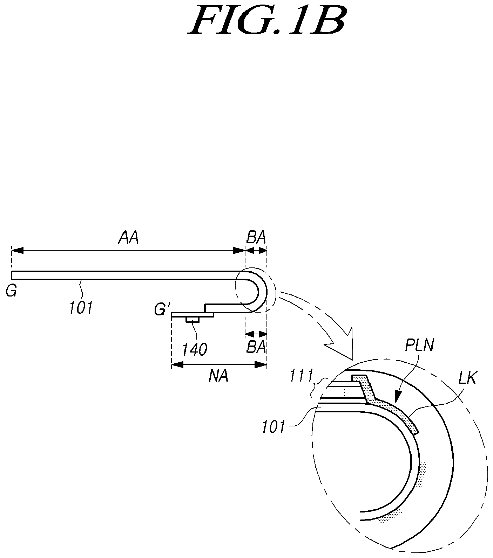

FIG. 1A is a schematic block diagram of an example organic light emitting display device 100 according to one embodiment of the present disclosure, and FIG. 1B is an example cross-sectional view of the organic light emitting display device 100 taken along line "G-G"' in FIG. 1 according to one embodiment of the present disclosure.

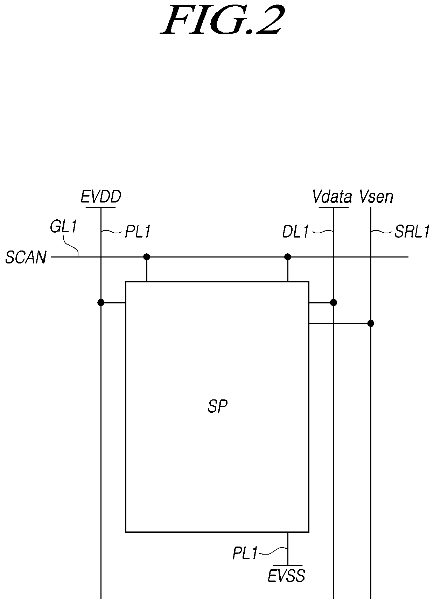

FIG. 2 is a schematic block diagram of an example subpixel illustrated in FIG. 1A according to one embodiment of the present disclosure.

As illustrated in FIG. 1A, the organic light emitting display device 100 may include an image processor 110, a degradation compensator 150, a memory 160, a timing controller 120, a data driver 140, a power supply 180, and a display panel PAN in which a gate driver 130 is disposed. The display panel PAN may include a display area AA and a non-display area NA. For example, the non-display area NA of the display panel PAN may include a bending area BA. The display panel PAN can be folded or bent in the bending area BA, and thus, a bezel of the display panel PAN may be reduced.

The image processor 110 can output driving or control signals for driving or controlling various elements or devices, as well as image data received from an external image data providing source. For example, such driving signals output from the image processor 110 may include a data enable signal, a vertical synchronization signal, a horizontal synchronization signal, a clock signal, and the like.

The degradation compensator 150 (e.g., a circuit) can calculate degradation compensation gain values of subpixels SP of the display panel based on sensing voltages Vsen received from the data driver 140, and calculate dimming weight values based on the degradation compensation gain values. Thereafter, the degradation compensator 150 can modulate input image data Idata of each subpixel SP in a current frame using the degradation compensation gain values and the dimming weight values, and supply image data Mdata resulting from the modulation to the timing controller 120.

The timing controller 120 can receive a driving signal and the like, in addition to the modulated image data from the degradation compensator 150. The timing controller 120 can generate and provide a gate timing control signal GDC for controlling an operation timing of the gate driver 130 and a data timing control signal DDC for controlling an operation timing of the data driver 140 based on one or more driving signals provided by the image processor 110.

The timing controller 120 can cause at least one sensing voltage Vsen from at least one subpixel SP to be acquired and to be supplied to the degradation compensator 150 by controlling operation timings of the gate driver 130 and the data driver 140.

The gate driver 130 can output a scan signal to the display panel PAN in response to a gate timing control signal GDC supplied by the timing controller 120. The gate driver 130 can output one or more scan signals through a plurality of gate lines GL1 to GLm. In an embodiment, the gate driver 130 may be implemented in the form of an integrated circuit (IC). However, examples of the present disclosure are not limited thereto. In particular, the gate driver 130 may be implemented in a gate in panel (GIP) structure in which one or more thin film transistors are directly stacked on a substrate inside of the organic light emitting display device 100. The gate driver 130 implemented in the GIP structure may include a plurality of circuit elements such as a shift register, a level shifter, and the like.

The data driver 140 can output a data voltage to the display panel PAN in response to a data timing control signal DDC supplied by the timing controller 120. The data driver 140 can sample and latch a digital data signal DATA received from the timing controller 120, and converts the digital data signal DATA into an analog data voltage based on a gamma voltage.

The data driver 140 can output one or more data voltages through a plurality of data lines DL1 to DLn.

The data driver 140 can supply a sensing voltage Vsen received from the display panel PAN to the degradation compensator 150 through a sensing voltage readout line.

In an embodiment, the data driver 140 may be mounted on the top surface or an upper edge of the display panel PAN in the form of an integrated circuit (IC) or may be directly disposed in the display panel PAN; however, examples of the present disclosure are not limited thereto.

The power supply 180 can output a high level driving voltage EVDD and a low level driving voltage EVSS to be supplied to the display panel PAN. The high level driving voltage VDD and the low level driving voltage EVSS may be supplied to the display panel PAN through one or more power supply lines. In an embodiment, the power supply 180 can supply voltages to the data driver 140 or the gate driver 130 for enabling the data driver 140 or the gate driver 130 to be driven.

The display panel PAN can display images based on data voltages and scan signals supplied from the data driver 140 and the gate driver 130 that may be disposed in the non-display area NA, and power such as voltages supplied from the power supply 180.

The display area AA of the display panel PAN may include a plurality of subpixels SP for displaying images. The plurality of subpixels SP may include one or more red subpixels, one or more green subpixels, and one or more blue subpixels, or include one or more white subpixels, one or more red subpixels, one or more green subpixels, and one or more blue subpixels. In an embodiment, all of the white subpixel, the red subpixel, the green subpixel and the blue subpixel may have a same area or size, or may have different areas or sizes.

The memory 160 may store a lookup table for degradation compensation gains and degradation compensation times of organic light emitting elements such as organic light emitting diodes of subpixels SP. For example, the degradation compensation times of the organic light emitting elements may be one or more times at which the organic light emitting display panel is driven, or the number of times that the organic light emitting display panel is driven.

In an embodiment, the non-display area NA may include the bending area BA in which the display panel PAN can be bent or folded. The bending area BA may be an area in which a signal pad (not shown), the gate driver 130, the data driver 140, and the like are located, and the function of displaying images is not performed, and be folded or bent toward the rear surface of the display area AA. The bending area BA may be located between the display area AA and the data driver 140 as illustrated in FIG. 1A. In an embodiment, the bending area BA may be disposed in at least one of the top, bottom, left, and right edges of the non-display area NA. Accordingly, an area occupied by the display area AA in the entire area of the display panel may be maximized, and the non-display area NA may be hidden behind the display area AA.

A signal link LK disposed in the bending area BA can connect a signal line disposed in the display area AA to a signal pad. The signal link LK may extend (e.g., the area thereof becomes greater) in a direction crossing a bending direction in which the bending area BA is folded or bent, and thereby, can enable bending stress to be reduced.

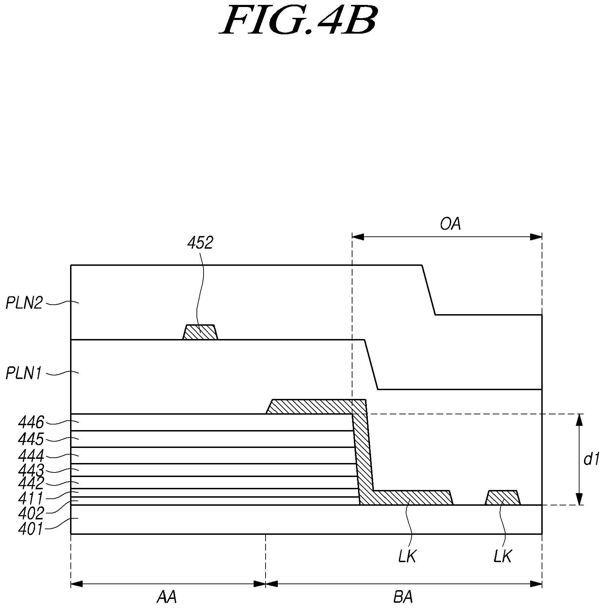

As illustrated in FIG. 4B, at least one opened portion OA may be disposed in the bending area BA so that the bending area BA can be easily folded or bent. The at least one opened portion OA may be formed by removing at least respective parts of a plurality of inorganic insulating layers 111 (shown in FIG. 1B) that may be disposed in the bending area BA and cause a crack. Specifically, when the substrate 101 is bent, continuous bending stress may be applied to at least one inorganic insulating layer 111 disposed in the bending area BA. Since the inorganic insulating layer 111 has an elastic force lower than an organic insulating material, a crack may easily develop in the inorganic insulating layer 111.

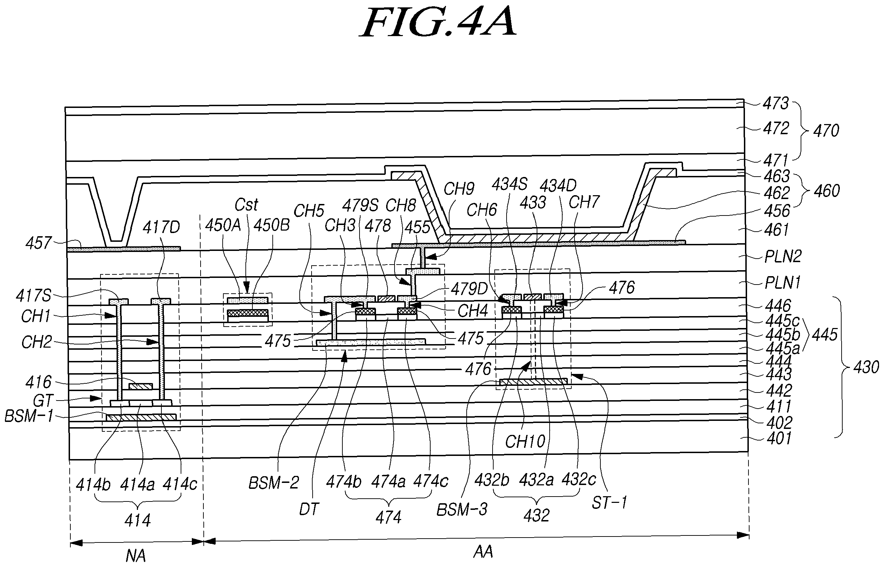

A crack having developed in the inorganic insulating layer 111 may run into the display area AA along the inorganic insulating layer 111, and the crack may cause a line defect and/or cause the driving of an associated element or device to fail. Accordingly, in an embodiment, at least one planarization layer PLN including an organic insulating material having a greater elasticity than the inorganic insulating layer 111 may be disposed in the bending area BA. The planarization layer PLN can relieve bending stress generating while the substrate 101 is bent or folded, and thereby, prevent or at least reduce cracks from developing. Since at least one opened portion OA of the bending area BA may be formed through a same mask process as at least one of a plurality of contact holes disposed in the display area AA, thereby, the structure of, and the process of forming, the at least one opened portion OA may be simplified. According to embodiments of the present disclose, a new structure of the display device is provided that is capable of solving damage of a semiconductor pattern when at least one opened portion OA of the bending area BA and at least one contact hole of the display area are formed. This structure will be described in detail with reference to FIGS. 4A and 4B.

In some embodiments, as illustrated in FIG. 2, one subpixel SP may be connected with a gate line GL1, a data line DL1, a sensing voltage readout line SRL1, and a power supply line PL1. The number of transistors and capacitors included in a subpixel SP as well as a driving method of the subpixel SP may vary depending on considerations for designing a circuit of the subpixel SP.

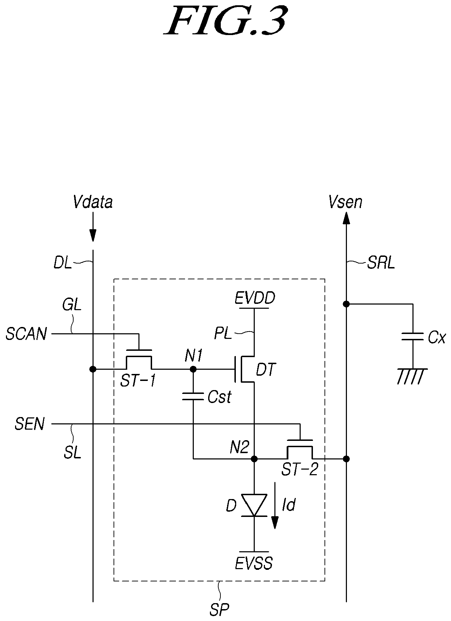

FIG. 3 is an example circuit diagram of a subpixel SP of the organic light emitting display device 100 according to one embodiment of the present disclosure.

As illustrated in FIG. 3, the organic light emitting display device 100 according to one embodiment of the present disclosure may include gate lines GL and data lines DL defining subpixels SP by being arranged in a manner of crossing each other, power supply lines PL, and sensing lines SL, and include a driving thin film transistor DT, an organic light emitting element D such as an organic light emitting diode, a storage capacitor Cst, a first switching thin film transistor ST-1, and a second switching thin film transistor ST-2, which are included in the subpixel SP.

The organic light emitting element D may include an anode electrode connected to a second node N2, a cathode electrode connected to a low level voltage supply line, or a terminal of a low level voltage supply, for supplying a low level driving voltage EVSS, and an organic emission layer located between the anode electrode and the cathode electrode.

The driving thin film transistor DT can control a current Id flowing through the organic light emitting element D according to a gate-source voltage Vgs. The driving thin film transistor DT may include a gate electrode connected to a first node N1, a drain electrode connected to a power supply line PL, to which a high level driving voltage EVDD is applied, and a source electrode connected to the second node N2.

The storage capacitor Cst may be connected between the first node N1 and the second node N2.

The first switching thin film transistor ST-1 can apply a data voltage Vdata loaded on a data line DL to the first node N1 in response to a gate signal SCAN when the display panel PAN is driven, and enable the driving thin film transistor DT to be turned on. In this example, the first switching thin film transistor ST-1 may include a gate electrode connected to the gate line GL, to which a scan signal SCAN is applied, a drain electrode connected to the data line DL, to which a data voltage Vdata is applied, and a source electrode connected to the first node N1.

The second switching thin film transistor ST-2 can enable a source voltage at the second node N2 to be stored in a sensing capacitor Cx of the voltage readout line SRL by switching a current between the second node N2 and the sensing voltage readout line SRL in response to a sensing signal SEN. The second switching thin film transistor ST-2 can reset the source voltage of the driving thin film transistor DT to an initialization voltage Vpre by switching the current between the second node N2 and the sensing voltage readout line SRL in response to the sensing signal SEN when the display panel PAN is driven. In this example, the gate electrode of the second switching thin film transistor ST-2 may be connected to the sensing line SL, the drain and source electrodes thereof may be connected to the second node N2 and the sensing voltage read-out line SRL, respectively.

Although the organic light emitting display device 100 having a structure including three thin film transistors (T) and one storage capacitor (C) (which may be referred to as a 3T1C structure) as illustrated in FIG. 3 has been discussed as an example, the organic light emitting display device 100 of the present disclosure is not limited to the specific structure. For example, the organic light emitting display device 100 of the present disclosure may have one or more of various structures such as 4T1C, ST1C, 6T1C, 7T1C, 8T1C, and the like.

FIG. 4A is a cross-sectional view of the organic light emitting display device 100 according to a first embodiment of the present disclosure, and illustrates one first thin film transistor GT including a polycrystalline semiconductor pattern as a representative thin film transistor disposed in a non-display area NA, for example, a GIP area, and a driving thin film transistor DT including an oxide semiconductor pattern, a first switching thin film transistor ST-1 including an oxide semiconductor pattern, and a storage capacitor Cst, which are disposed inside of a subpixel in the display area AA and configured to drive an organic electroluminescent element such as an organic light emitting diode.

As illustrated in FIG. 4A, the driving thin film transistor DT and the first switching thin film transistor ST-1 may be disposed in the subpixel over a substrate 401. Although FIG. 4A illustrates the driving thin film transistor DT and one switching thin film transistor ST-1, this is merely for convenience of description, and in an actual implementation, a plurality of switching thin film transistors may be disposed over the substrate 401.

In an embodiment, one or more first thin film transistors GT included in the gate driver may be disposed in the non-display area NA of the substrate 401, for example, the GIP area. The first thin film transistor GT may be a thin film transistor employing a polycrystalline semiconductor pattern as an active layer.

Although discussions on the first embodiment are provided based on an example where the first thin film transistor GT including the polycrystalline semiconductor pattern is disposed in the non-display area NA, however, a switching thin film transistor having the same structure as the first thin film transistor GT including the polycrystalline semiconductor pattern may be disposed in a subpixel of the display area of the organic light emitting display device 100 according to the first embodiment.

However, the first thin film transistor GT disposed in the non-display area and a first thin film transistor disposed in the display area may be doped with different types of impurities. For example, one of the thin film transistors may be one of an N-type thin film transistor and a P-type thin film transistor, and the other one of the thin film transistors may be the other of the N-type thin film transistor and the P-type thin film transistor.

In an embodiment, a plurality of thin film transistors disposed in the gate driver may be transistors using CMOS technology in which a first thin film transistor including a polycrystalline semiconductor pattern and a second thin film transistor including an oxide semiconductor pattern are paired with each other.

Hereinafter, discussions will be provided on an example where the first thin film transistor using the polycrystalline semiconductor pattern is disposed in the non-display area NA.

The first thin film transistor GT may include a first polycrystalline semiconductor pattern 414 disposed on a lower buffer layer 402 and/or 411 disposed on the substrate 401, a first gate insulating layer 442 for insulating the first polycrystalline semiconductor pattern 414, a first gate electrode 416 disposed on the first gate insulating layer 442 and overlapping the first polycrystalline semiconductor pattern 414, a plurality of insulating layers disposed on the first gate electrode 416, and a first source electrode 417S and a first drain electrode 417D disposed on the plurality of insulating layers.

The first thin film transistor GT may further include a first light shield pattern BSM-1, which is located under the first polycrystalline semiconductor pattern 414, for protecting the first polycrystalline semiconductor pattern 414 from light coming from the outside. In an embodiment, the first light shield pattern BSM-1 may not be needed. Thus, the first light shield pattern BSM-1 may be selectively formed according to design considerations.

The first light shield pattern BSM-1 may be a metal pattern formed on the first lower buffer layer 402. The material of the first light shield pattern BSM-1 according to embodiments of the present disclosure are not limited to such a thin film metal.

The first light shield pattern BSM-1 may be formed under the first polycrystalline semiconductor pattern 414 and have a larger size than the first polycrystalline semiconductor pattern 414 in order to completely shield external light from entering the first polycrystalline semiconductor pattern 414. For example, the first light shield pattern BSM-1 may completely overlap the first polycrystalline semiconductor pattern 414.

The substrate 401 may have a multilayer structure in which an organic layer and an inorganic layer are alternately stacked. For example, the substrate 401 may be formed such that an organic layer such as polyimide and an inorganic layer such as silicon oxide (SiO2) are alternately stacked.

The first lower buffer layer 402 may be disposed on the substrate 401. The first lower buffer layer 402 can block or at least reduce moisture and the like that may penetrate from the outside, and may be formed such that at least one silicon oxide (SiO2) film and/or the like are stacked to form a multilayer.

The first light shield pattern BSM-1 may be disposed on the first lower buffer layer 402 so as to be between the substrate 401 and the first polycrystalline semiconductor pattern 414.

A second lower buffer layer 411 may be further disposed on the first light shield pattern BSM-1. The second lower buffer layer 411 may include the same material as the first lower buffer layer 402.

The first polycrystalline semiconductor pattern 414 may be disposed on the second lower buffer layer 411 such that the second lower buffer layer 411 is between the first polycrystalline semiconductor pattern 414 and the first light shield pattern BSM-1. The first polycrystalline semiconductor pattern 414 may be formed with a polycrystalline semiconductor, and include a first channel region 414a through which charges move, and a first source region 414b and a first drain region 414c adjacent to the first channel region 414a that is interposed between the first source region 414b and the first drain region 414c. The first source region 414b and the first drain region 414c may be conductive regions resulting from doping impurity ions such as phosphorus or boron in an intrinsic polycrystalline semiconductor pattern.

The first polycrystalline semiconductor pattern 414 can be insulated from the first gate electrode 416 by the first gate insulating layer 442. The first gate insulating layer 442 may be formed from the deposition of an inorganic insulating layer such as silicon oxide (SiO2) on the entire surface of the substrate 401 on which the first polycrystalline semiconductor pattern 414 is formed. The first gate insulating layer 442 can protect and insulate the first polycrystalline semiconductor pattern 414 from the outside.

The first gate electrode 416 overlapping the first channel region 414a of the first polycrystalline semiconductor pattern 414 may be disposed on the first gate insulating layer 442.

The first gate electrode 416 may include a metal material. For example, the first gate electrode 416 may be formed from a single layer or a multilayer including one or more, or one or more of alloys including two or more, of molybdenum (Mo), aluminum (Al), chromium (Cr), gold (Au), titanium (Ti), nickel (Ni), neodymium (Nd), and copper (Cu); however, embodiments of the present disclosure are not limited thereto.

A plurality of insulating layers may be disposed between the first gate electrode 416 and the first source and drain electrodes (417S and 417D).

Referring to FIG. 4A, the plurality of insulating layers may include a first interlayer insulating layer 443 contacting the top surface of the first gate electrode 416, and a second interlayer insulating layer 444, an upper buffer layer 445, and a second gate insulating layer 446, which are sequentially stacked on the first interlayer insulating layer 443. In some embodiments, the second interlayer insulating layer 444 may be omitted.

The first source electrode 417S and the first drain electrode 417D may be disposed on the second gate insulating layer 446. The first source electrode 417S and the first drain electrode 417D may be respectively connected to the first source region 414b and the first drain region 414c through a first contact hole CH1 and a second contact hole CH2 passing through the first gate insulating layer 442, the first interlayer insulating layer 443, the second interlayer insulating layer 444, the upper buffer layer 445, and the second gate insulating layer 446.

The driving thin film transistor DT, the first switching thin film transistor ST-1, and the storage capacitor Cst may be disposed in the subpixel of the display area AA.

In the first embodiment, the driving thin film transistor DT and the first switching thin film transistor ST-1 may employ an oxide semiconductor pattern as an active layer.

The driving thin film transistor DT may include a first oxide semiconductor pattern 474, a second gate electrode 478 overlapping the first oxide semiconductor pattern 474, second source electrode 479S, and second drain electrode 479D.

The first oxide semiconductor pattern 474 may include an oxide of a metal such as zinc (Zn), indium (In), gallium (Ga), tin (Sn), titanium (Ti), or the like, or a combination of a metal such as zinc (Zn), indium (In), gallium (Ga), tin (Sn), titanium (Ti), or the like and an oxide of zinc (Zn), indium (In), gallium (Ga), tin (Sn), titanium (Ti), or the like. More specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), or the like.

In the conventional technology, a polycrystalline semiconductor pattern advantageous for high speed operation has been used as an active layer of a driving thin film transistor. However, the driving thin film transistor including the polycrystalline semiconductor pattern has suffered from a leakage current flowing in an off state and power consumption caused by the leakage current. In particular, such power consumption caused in the off state becomes more problematic when the display device operates at a low speed as in a situation of displaying a still image such as a textual document, a photograph, and the like. According to the first embodiment of the present disclose, the display device 100 may include driving thin film transistors including the oxide semiconductor pattern advantageous for preventing or reducing leakage current as an active layer.

In the example where a thin film transistor employs an oxide semiconductor pattern as an active layer, since a current fluctuation value for a unit voltage fluctuation value is large due to the material characteristics of the oxide semiconductor, there often occur display artifacts at low grayscales where accurate current control is required. To address this issue, according to the first embodiment of the present disclose, the display device 100 may include a driving thin film transistor in which a current fluctuation value in an active layer is relatively less affected by a fluctuation value of a voltage applied to a gate electrode.

Referring to FIG. 4A, the driving thin film transistor DT may include the first oxide semiconductor pattern 474 located on the upper buffer layer 445, the second gate insulating layer 446 covering the first oxide semiconductor pattern 474, the second gate electrode 478 disposed on the second gate insulating layer 446 and overlapping the first oxide semiconductor pattern 474, and the second source electrode 479S and the second drain electrode 479D disposed on or in the same layer as the second gate electrode 478.

The first oxide semiconductor pattern 474 serving as an active layer may include a second channel region 474a through which charges move, and a second source region 474b and a second drain region 474c adjacent to the second channel region 474a that is interposed between the second source region 474b and the second drain region 474c. In an embodiment, first conductive patterns 475 may be disposed in respective upper edges (e.g., upper surfaces) of the second source region 474b and the second drain region 474c of the first oxide semiconductor pattern 474. That is, a first conductive pattern may be in contact with and overlap the second source region 474b and another first conductive pattern may be in contact with and overlap the second drain region 474c. The first conductive pattern is non-overlapping with the second channel region 474a. The first conductive patterns 475 can cause the second source region 474b and the second drain region 474c to function as conductors.

The first conductive patterns 475 may be conductive metal patterns. For example, the first conductive patterns 475 may be transparent or opaque metal layers such as Mo, Ti, MoTi, IZO, ITO, Cu, Al, or the like. In particular, the first conductive patterns 475 may be conductive patterns allowing an ohmic contact for reducing a surface contact resistance considering that the first conductive patterns 475 have surface contact (e.g., direct contact) with the second source region 474b and the second drain region 474c formed from the oxide semiconductor pattern. In an embodiment, the first conductive pattern 475 may be a conductive pattern having a great degree of etching resistance compared to the second gate insulating layer 446, which is an inorganic insulating layer, when a third contact hole CH3 for connecting the second source electrode 479S with the second source region 474b is formed in the second gate insulating layer 446. That is, when the third contact hole CH3 is formed through the etching of the second gate insulating layer 446, which is the inorganic insulating layer, the first conductive pattern 475 located in an upper edge (e.g., the upper surface) of the second source region 474b can resist the etching and protect the second source region 474b from etching gas.

The second channel region 474a may include an intrinsic oxide semiconductor in which impurities are not doped. Since the first conductive patterns 475 are located in respective upper edges (e.g., upper surfaces) of the second source region 474b and the second drain region 474c, each of the second source region 474b and the second drain region 474c may include an intrinsic oxide semiconductor.

A second light shield pattern BSM-2 may be formed under the first oxide semiconductor pattern 474 so as to overlap the first oxide semiconductor pattern 474. The second light shield pattern BSM-2 can prevent or at least reduce external light from reaching the first oxide semiconductor pattern 424 and prevent or at least reduce the first oxide semiconductor pattern 424 from malfunctioning due to the external light.

The second light shield pattern BSM-2 may be a metal layer including a titanium (Ti) material capable of trapping hydrogen particles. For example, the second light shield pattern BSM-2 may be formed from a single layer of titanium or a multilayer of molybdenum (Mo) and titanium (Ti), or include an alloy of molybdenum (Mo) and titanium (Ti). However, embodiments of the present disclosure are not limited thereto. For example, the second light shield pattern BSM-2 may be also formed from another metal layer including titanium (Ti).

Titanium (Ti) can trap hydrogen particles diffusing into the upper buffer layer 445 to prevent the hydrogen particles from reaching the first oxide semiconductor pattern 474.

In an embodiment, the second light shield pattern BSM-2 may be disposed vertically under the first oxide semiconductor pattern 474 so that the second light shield pattern BSM-2 can overlap the first oxide semiconductor pattern 474. In an embodiment, the second light shield pattern BSM-2 may have a greater size or area than the first oxide semiconductor pattern 474 so that the second light shield pattern BSM-2 can completely overlap the first oxide semiconductor pattern 474.

In an embodiment, the second source electrode 479S of the driving thin film transistor DT may be electrically connected to the second light shield pattern BSM-2. In the example where the second light shield pattern BSM-2 is electrically connected to the second source electrode 479S, additional advantages can be obtained as described below.

As the first conductive patterns 475 are located on the upper edges (e.g., upper surfaces) of the second source region 474b and the second drain region 474c of the first oxide semiconductor pattern 474, a parasitic capacitance $C_{act}$ may be formed inside of the first oxide semiconductor pattern 474, a parasitic capacitance $C_{gi}$ may be formed between the second gate electrode 478 and the first oxide semiconductor pattern 474, and a parasitic capacitance $C_{buf}$ may be formed between the second light shield pattern BSM-2 electrically connected to the second source electrode 479S and the first oxide semiconductor pattern 474.

The first oxide semiconductor pattern 474 and the second light shield pattern BSM-2 may be electrically connected by the second source electrode 479S. Therefore, the parasitic capacitance $C_{act}$ and the parasitic capacitance $C_{buf}$ may be connected in parallel with each other, and the parasitic capacitance $C_{act}$ and the parasitic capacitance $C_{gi}$ may be connected in series. When a gate voltage of $V_{gat}$ is applied to the second gate electrode 478, an effective voltage $V_{eff}$ actually applied to the first oxide semiconductor pattern 474 can be obtained by Equation 1 below.

$$\Delta V = Cgi/(Cgi + Cact + Cbuf) \times \Delta Vgat$$

Accordingly, since the effective voltage $V_{eff}$ applied to the second channel region 474a is in inverse proportion to the parasitic capacitance $C_{buf}$, the effective voltage applied to the first oxide semiconductor pattern 474 can be adjusted by adjusting the parasitic capacitance $C_{buf}$.

For example, when the second light shield pattern BSM-2 is disposed close to the first oxide semiconductor pattern 474 to increase the parasitic capacitance $C_{buf}$, an actual current value flowing through the first oxide semiconductor pattern 474 can be reduced.

The reduction of the effective current value flowing through the first oxide semiconductor pattern 474 may mean that the s-factor of the driving thin film transistor DT can be increased, and that a control range of the driving thin film transistor DT that can be controlled through the voltage $V_{gat}$ actually applied to the second gate electrode 478 can be widened.

Thus, when the second source electrode 474S of the driving thin film transistor DT and the second light shield pattern BSM-2 are electrically connected, an organic light emitting element such as an organic light emitting diode can be accurately controlled even at low grayscales, and thereby, display artifacts such as color differences, screen blotches, and the like occurring frequently at low grayscales can be solved.

Here, the s-factor is sometimes referred to as a "sub-threshold slope" and represents a voltage required when a current rises 10 times. In a graph showing the characteristics of drain current versus gate voltage (I-V curve), the s-factor equals to an inverse value of a slope of the graph in a range below a threshold voltage.

A situation where the s-factor is small may mean that the slope of the characteristic graph (I-V) of the drain current with respect to the gate voltage is large. In this situation, a corresponding thin film transistor can be turned on even by a small voltage, and thus, the switching characteristics of the thin film transistor can be improved. However, as the threshold voltage is reached over a short time, corresponding grayscales may not be sufficient to accurately display images.

A situation where the s-factor is large may mean that the slope of the characteristic graph (I-V) of the drain current with respect to the gate voltage is small. In this situation, while the on/off response speed of a corresponding thin film transistor can be reduced, corresponding grayscales may be sufficient to accurately display images as the threshold voltage is reached over a relatively long time.

For example, the second light shield pattern BMS-2 may be disposed close to the first oxide semiconductor pattern 474 as the second light shield pattern BMS-2 is inserted inside of the upper buffer layer 445. In the first embodiment, the upper buffer layer 445 may include a plurality of sub-upper buffer layers. For example, the upper buffer layer 445 may have a structure in which a first sub-upper buffer layer 445a, a second sub-upper buffer layer 445b, and a third sub-upper buffer layer 445c are sequentially stacked. The second light shield pattern BSM-2 may be disposed on the first sub-upper buffer layer 445a such that one or more of the sub-upper buffer layers (e.g., the second sub-upper buffer layer 445b and the third sub-upper buffer layer 445c) are between the second light shield pattern BSM-2 and the first oxide semiconductor pattern 474. As a result, a vertical distance is formed between the second light shield pattern BSM-2 and the first oxide semiconductor pattern 474. In an embodiment, the second sub-upper buffer layer 445b may completely cover the second light shield pattern BSM-2. The third sub-upper buffer layer 445c may be disposed on the second sub-upper buffer layer 445b.

The first sub-upper buffer layer 445a and the third sub-upper buffer layer 445c may include silicon oxide (SiO2).

The first sub-upper buffer layer 445a and the third sub-upper buffer layer 445c may include silicon oxide (SiO2) not containing hydrogen particles, and therefore, the oxide semiconductor pattern can be protected from hydrogen particles that may penetrate during a heat treatment process. If hydrogen particles penetrate the oxide semiconductor pattern, the reliability of the thin film transistor may be lowered.

To address this issue, in an embodiment, the second sub-upper buffer layer 445b may include silicon nitride (SiNx) having excellent ability to trap hydrogen particles. The second sub-upper buffer layer 445b may be formed at least partially on the first sub-upper buffer layer 445a such that all of the top surface and side surfaces of the second light shield pattern BSM-2 are covered to completely seal the second light shield pattern BSM-2. In an embodiment, the second sub-upper buffer layer 445b may be formed on the entire surface of the first sub-upper buffer layer 445a on which the second light shield pattern BSM-2 is formed.

Silicon nitride (SiNx) can generally have a better ability to trap hydrogen particles than silicon oxide (SiO2). When hydrogen particles penetrate an oxide semiconductor pattern (e.g., the first oxide semiconductor pattern 474), the oxide semiconductor may have different threshold voltages or allow the conductivity of a channel thereof to vary depending on locations where the hydrogen particles are formed. As a result, the reliability of a corresponding thin film transistor may be lowered. In particular, in the case of a driving thin film transistor (e.g., the driving thin film transistor DT), which directly contributes to the operation of a light emitting element, it is important to establish the reliability of the driving thin film transistor.

Accordingly, in the embodiment of the present disclosure, the lowering of the reliability of the driving thin film transistor that may be caused by hydrogen particles can be prevented or at least reduced by partially or entirely forming the second sub-upper buffer layer 445b covering the second light shield pattern BMS-2 on the first sub-upper buffer layer 445a.

In the first embodiment, the second light shield pattern BSM-2 may be a metal layer including a titanium (Ti) material capable of trapping hydrogen particles. For example, the second light shield pattern BSM-2 may be formed from a single layer of titanium or a multilayer of molybdenum (Mo) and titanium (Ti), or include an alloy of molybdenum (Mo) and titanium (Ti). However, embodiments of the present disclosure are not limited thereto. For example, the second light shield pattern BSM-2 may be also formed from another metal layer including titanium (Ti).

Titanium (Ti) can trap hydrogen particles diffusing into the upper buffer layer 445 to prevent the hydrogen particles from reaching the first oxide semiconductor pattern 474. Accordingly, in the driving thin film transistor DT of the organic light emitting display device 100 according to embodiments of the present disclosure, the lowering of the reliability of the oxide semiconductor pattern that may be caused by hydrogen particles can be prevented or at least reduced because the second light shield pattern BSM-2 is formed with a metal layer such as titanium capable of trapping hydrogen particles, and the second light shield pattern BSM-2 is covered with the silicon nitride (SiNx) layer capable of trapping hydrogen particles.

Since the second sub-upper buffer layer 445b is formed from a material (i.e., the silicon nitride (SiNx) film) different from the first sub-upper buffer layer 445a, film lifting may occur in a situation where the second sub-upper buffer layer 445b is deposited in the entire area of the display area. To address this issue, the second sub-upper buffer layer 445b may be selectively formed a desired portion, that is, in a portion where the second light shield pattern BSM-2 is formed.

In an embodiment, the second light shield pattern BSM-2 may be disposed vertically under the first oxide semiconductor pattern 474 so that the second light shield pattern BSM-2 can overlap the first oxide semiconductor pattern 474. In an embodiment, the second light shield pattern BSM-2 may have a greater size or area than the first oxide semiconductor pattern 474 so that the second light shield pattern BSM-2 can completely overlap the first oxide semiconductor pattern 474.

The second gate electrode 478 of the driving thin film transistor DT may be disposed over the first oxide semiconductor pattern 474. The second gate electrode 478 may overlap the second channel region 474a. The second gate insulating layer 446 may be interposed between the second gate electrode 478 and the first oxide semiconductor pattern 474.

The second source electrode 479S and the second drain electrode 479D may be formed in or on the same layer as the second gate electrode 478. For example, the second gate electrode 478, the second source electrode 479S, and the second drain electrode 479D may be formed on the second gate insulating layer 446 simultaneously or together.

In the first embodiment of the present disclosure, the second source electrode 479S and the second drain electrode 479D respectively overlapping the second source region 474b and the second drain region 474c can be formed on the second gate insulating layer 446 as impurity ions are not doped into the second source region 474b and the second drain region 474c. For example, the second gate electrode 478, the second source electrode 479S, and the second drain electrode 479D can be formed simultaneously or together. Thus, the effect of reducing the number of masks can be obtained.

The second source electrode 479S may be connected to the first conductive pattern 475 located on the upper edge (e.g., upper surface) of the second source region 474b through the third contact hole CH3 passing through the second gate insulating layer 446, and the second drain electrode 479D may be connected to the first conductive pattern 475 located on the upper edge (e.g., upper surface) of the second drain region 474c through a fourth contact hole CH4.

In an embodiment, the second source electrode 474S may be electrically connected to the second light shield pattern BSM-2 through a fifth contact hole CH5.

In an embodiment, the first switching thin film transistor ST-1 may include a second oxide semiconductor pattern 432, a third gate electrode 433, a third source electrode 434S, and a third drain electrode 434D.

The second oxide semiconductor pattern 432 may include a third channel region 432a, a third source region 423b and a third drain region 432c adjacent to the third channel region 432a that is interposed between the third source and drain regions 432b and 432c. In particular, similarly as in the driving thin film transistor DT, second conductive patterns 476 may be disposed in respective upper edges (e.g., upper surfaces) of the third source region 432b and the third drain region 432c. For example, a second conductive pattern 476 may in contact with and overlap the third source region 423b and another second conductive pattern 476 may be in contact with and overlap the third drain region 423c without being in contact with and without overlapping the third channel region 432a. The second conductive patterns 476 may include the same material as the first conductive patterns 475.

The third gate electrode 433 may be located on the second gate insulating layer 446 located on the second oxide semiconductor pattern 432.

The third source electrode 434S and the third drain electrode 434D may be formed in or on the same layer as the third gate electrode 433. For example, the third source electrode 434S, the third drain electrode 434D, and the third gate electrode 433 may be formed simultaneously or together with a same material on the second gate insulating layer 446.

In an embodiment, a third light shield pattern BSM-3 may be disposed under the second oxide semiconductor pattern 432.

The third light shield pattern BSM-3 may be disposed under the second oxide semiconductor pattern 432 while overlapping the second oxide semiconductor pattern 432 in order to protect the second oxide semiconductor pattern 432 from light coming from the outside.

The third light shield pattern BSM-3 may be disposed on the first gate insulating layer 442 or the first interlayer insulating layer 443 with a plurality of layers between the third light shield pattern BSM-3 and the second oxide semiconductor pattern 432. For example, the first interlayer insulating layer 443, the first sub-upper buffer layer 445a, the second sub-upper buffer layer 445b and the third sub-upper buffer layer 445c may be between the third light shield pattern BSM-3 and the second oxide semiconductor pattern 432. As a result, a vertical distance between the third light shield pattern BSM-3 and the second oxide semiconductor pattern 432 is greater than the vertical distance between the second light shield pattern BSM-2 and the first oxide semiconductor pattern 474. That is, the vertical distance between the second light shield pattern BSM-2 and the first oxide semiconductor pattern 474 is less than the vertical distance between the third light shield pattern BSM-3 and the second oxide semiconductor pattern 432.

The third gate electrode 433 and the third light shield pattern BSM-3 may be electrically connected to each other through a tenth contact hole CH10 to form a dual gate.

Referring to FIG. 4A, the subpixel may further include a storage capacitor Cst.

The storage capacitor Cst may store a data voltage applied through a data line for a certain period of time, and provide the data voltage to an organic light emitting element such as an organic light emitting diode.

The storage capacitor Cst may include two electrodes corresponding to each other and a dielectric disposed therebetween. The storage capacitor Cst may include a first electrode 450A including the same material, and disposed in the same layer, as the second gate electrode 478, and a second electrode 450B corresponding to the first electrode 450A and having the same stacked structure as that of the first oxide semiconductor pattern 474 and the first conductive patterns 475.

The second gate insulating layer 446 may be interposed between the first electrode 450A and the second electrode 450B of the storage capacitor Cst.

The first electrode 450A of the storage capacitor may be electrically connected to the second source electrode 479S.

In the display device 100 according to the first embodiment of the present disclosure, since a plurality of metal patterns are included, and a plurality of contact holes are needed to be formed, it may be desired to reduce steps of mask processing, for example, number of masks or number of times that one or more masks are used.

Accordingly, the first gate electrode 416 and the third light shield pattern BSM-3 may be formed using a single mask by allowing the first gate electrode 416 and the third light shield pattern BSM-3 to be disposed on or in the same layer.

In an embodiment, the first oxide semiconductor pattern 474 and the first conductive patterns 475 disposed thereon, and the second oxide semiconductor pattern 432 and the second conductive patterns 476 disposed thereon may be formed simultaneously or together using a single mask.

In an embodiment, the first source electrode 417S and the first drain electrode 417D, the second gate electrode 478, the second source electrode 479S and the second drain electrode 479D, the third gate electrode 433, and the third source electrode 434S and the third drain electrode 434D may be disposed on or in the same layer, and therefore, may be formed simultaneously or together using one mask.

In the display device 100 according to the first embodiment of the present disclosure, it may be desired to form a plurality of contact holes (e.g., CH1 to CH7), and to reduce steps of mask processing, the first to seventh contact holes (CH1 to CH7) may be formed simultaneously or together. That is, since the third contact hole CH3 and the first contact hole CH1 have different depths, when the etching process is performed at the same time, the first oxide semiconductor pattern 474 disposed under the third contact hole CH3 may be damaged because it can be exposed to etching gases for a long time. However, in the display device 100 according to the first embodiment of the present disclosure, since when the inorganic insulating layers under the third contact hole CH3 are etched, the first conductive patterns 475, which are hardly etched, are disposed, the first to seventh contact holes (CH1 to CH7) having different depths from one another may be disposed simultaneously or together without being damaged.

Referring to FIG. 4B, when the first to seventh contact holes (CH1 to CH7) are formed, an opened portion OA may be formed by removing the inorganic insulating layers (for example, within a height of d1 from the substrate 401) deposited in the bending area BA of the non-display area NA. As a result, an associated thin film transistor array substrate can be manufactured while reducing the number of masks.

In an embodiment, referring to FIG. 4A, a first planarization layer PLN1 may be formed on the substrate 401 on which the driving thin film transistor DT and the first switching thin film transistor ST-1 are disposed. The first planarization layer PLN1 may include an organic material such as photoacrylic, or may be formed from a plurality of layers including an inorganic layer and an organic layer. A connection electrode 455 may be disposed on the first planarization layer PLN1. The connection electrode 455 can electrically connect an anode electrode 456, which is an element of a light emitting element 460, to the driving thin film transistor DT through an eighth contact hole CH8 formed in the first planarization layer PLN1.

In an embodiment, a conductive layer used when the connection electrode 455 is formed may form a portion of a link line 452 in the bending area BA.

The second planarization layer PLN2 may be disposed on the connection electrode 455. As in the first planarization layer PLN1, the second planarization layer PLN2 may include an organic material such as photoacrylic, or may be formed from a plurality of layers including an inorganic layer and an organic layer.

The anode electrode 456 may be disposed on the second planarization layer PLN2. The anode electrode 456 may be electrically connected to the connection electrode 455 through a ninth contact hole CH9 formed in the second planarization layer PLN2.

The anode electrode 456 may be formed from a single layer or a multilayer including one or more, or one or more of alloys including two or more, of metals such as Ca, Ba, Mg, Al, Ag, or the like, and may be connected to the second drain electrode 427D of the driving thin film transistor DT, so that an image signal can be applied to the anode electrode 456.

In addition to the anode electrode 456, an anode connection electrode 457 for electrically connecting a common voltage line VSS to a cathode electrode 463 may be further disposed in the non-display area NA.

A bank layer 461 may be disposed on the second planarization layer PLN2. The bank layer 461 may be a type of partition for partitioning each subpixel, and can protect the subpixel by preventing or at least reducing light of a specific color output from an adjacent subpixel from being mixed to light emitted from the subpixel.

An organic emission layer 462 may be disposed on the surface of the anode electrode 456 and on at least a portion of an inclined surface of the bank layer 461. The organic emission layer 462 may be disposed in each subpixel, and may be an R organic emission layer emitting red light, a G organic emission layer emitting green light, or a B organic emission layer emitting blue light. In an embodiment, the organic emission layer 462 may be a W organic light emitting layer emitting white light.

The organic emission layer 462 may include the emission layer, an electron injection layer, a hole injection layer for respectively injecting electrons and holes into the emission layer, an electron transport layer, and a hole transport layer for respectively transporting the injected electrons and holes to an organic layer.

The cathode electrode 463 may be disposed on the organic emission layer 462. The cathode electrode 463 may include a transparent conductive material such as indium tin oxide (ITO) or indium zinc oxide (IZO), or a thin metal through which visible light is transmitted, but embodiments of the present disclosure are not limited thereto.

An encapsulation layer 470 may be disposed on the cathode electrode 463. The encapsulation layer 470 may be formed from a single layer including an inorganic layer, may be formed from two layers of an inorganic layer and an organic layer, or may be formed from three layers of an inorganic layer, an organic layer, and an inorganic layer. The inorganic layer may include an inorganic material such as $SiN_x$, $SiO_x$, and the like, but embodiments of the present disclosure are not limited thereto. In some embodiments, the organic layer may include an organic material such as polyethylene terephthalate, polyethylene naphthalate, polycarbonate, polyimide, polyethylene sulfonate, polyoxymethylene, polyarylate, or the like, or a mixture thereof, but embodiments of the present disclosure are not limited thereto.

In an embodiment, FIG. 4A illustrates the encapsulation layer 470 formed from a plurality of layers of an inorganic layer 471, an organic layer 472, and an inorganic layer 473.

A cover glass (not shown) may be disposed on the encapsulation layer 470, and for example, be attached using an adhesive layer (not shown). As the adhesive layer, although any material may be used as long as it has good adhesion and good heat resistance and water resistance, in some embodiments, a thermosetting resin such as an epoxy-based compound, an acrylate-based compound, or an acrylic rubber may be used. In an embodiment, a photocurable resin may be used as the adhesive layer, and the adhesive layer may be cured by irradiating the adhesive layer with light such as ultraviolet rays.

The adhesive layer can serve as an encapsulant for preventing or at least reducing the penetrating of moisture into the organic light emitting display device, as well as bonding the substrate 401 and the cover glass (not shown).

For example, a protective film such as a polystyrene (PS) film, a polyethylene (PE) film, a polyethylene naphthalate (PEN) film, a polyimide (PI) film, or the like, or glass may be used as the cover glass (not shown) serving as an encapsulation cap for encapsulating the organic light emitting display device 100.

--A second embodiment--

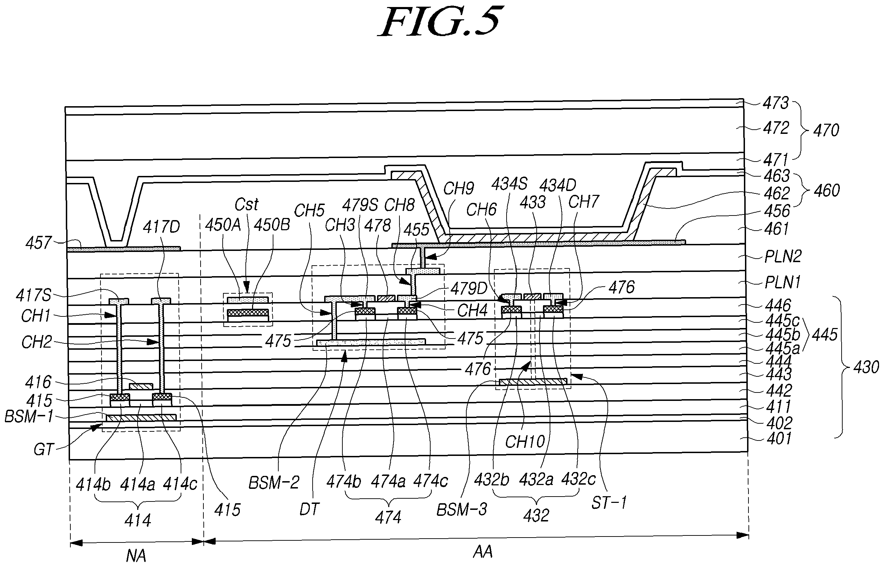

The second embodiment of the present disclosure will be described with reference to FIG. 5. The display area AA and the non-display area NA of the display device 100 according to the second embodiment may be basically based on configurations of, and have nearly the same configurations as, the display area AA and the non-display area NA of the display device 100 according to the first embodiment as described above. In the second embodiment, a first thin film transistor GT disposed in the non-display area NA may have third conductive patterns 415 disposed in respective upper edges of source and drain regions as in the first oxide semiconductor pattern 474 of the driving thin film transistor DT. Thus, considering similarity between the first and second embodiments and for convenience of description, discussions on the second embodiment will be provided only for the different configurations between the first and second embodiments.

Referring to FIG. 5, in the second embodiment, the first thin film transistor GT may include third conductive patterns 415 on a first polycrystalline semiconductor pattern 414. The third conductive patterns 415 may have basically the same configuration as the first conductive patterns 475 and the second conductive patterns 476. A first polycrystalline semiconductor pattern 414 may include a first source region 414b, a first drain region 414c, and a first channel region 414a. The third conductive patterns 415 may be disposed in respective upper edges (e.g., upper surfaces) of the first source region 414b and the first drain region 414c. For example, the third conductive patterns 415 may contact the respective top surfaces of the first source region 414b and the first drain region 414c. That is, a third conductive pattern 415 may be in contact with and overlap the first source region 414b and another third conductive pattern 415 may be in contact with and overlap the first drain region 414c without being in contact with and without overlapping the first channel region 414a.

The material of the third conductive patterns 415 may be the same as that of the first conductive patterns 475 described in the first embodiment. The third conductive patterns 415 can provide conductivity to the first source region 414b and the first drain region 414c for supplementing the low conductivity of the first source region 414b and the first drain region 414c. Therefore, since it is not necessary to implant impurity ions into the first source region 414b and the first drain region 414c in order to make them become conductive, the first source region 414b and the first drain region 414c can remain in an intrinsic semiconductor state.

Considering that the third conductive patterns 415 directly contact the first source region 414b and the first drain region 414c, the third conductive patterns 415it may be desired to have a low sheet resistance. Accordingly, in order to have a low sheet resistance, the third conductive patterns 415 may be metal patterns that ohmically contact the first source region 414b and the first drain region 414c.

The first polycrystalline semiconductor pattern 414 and the third conductive patterns 415 may be formed simultaneously or together using a halftone mask. That is, after continuously depositing the polycrystalline semiconductor layer and conductive layers on a second lower buffer layer 411, the first polycrystalline semiconductor pattern 414 and the third conductive patterns 415 may be formed using the halftone mask. The first polycrystalline semiconductor pattern 414 and the third conductive patterns 415 can be formed through a single mask process.

The process of forming the semiconductor pattern and the conductive patterns in the upper edges (e.g., upper surfaces) of the semiconductor pattern may be applied to all embodiments of the present disclosure.

The third conductive patterns 415 can have a greater ability to resist etching than inorganic interlayer insulating layers. For example, when a contact hole passing through the inorganic interlayer insulating layers is formed using a dry etching method, the third conductive patterns 415 may be hardly etched by the etching gas used for the dry etching.

Accordingly, the third conductive patterns 415 can protect the first polycrystalline semiconductor pattern 414, which may be exposed to the etching gas for a long time, from the etching gas while forming first and second contact holes (CH1 and CH2) having relatively long depths.

The third conductive patterns 415 may have the following additional advantages in addition to advantages provided in the first embodiment.

As described in the first embodiment, first to seventh contact holes (CH1 to CH7) may be formed simultaneously or together to reduce the number of masks used, and in this situation, an opened portion OA of the bending area BA may be formed simultaneously or together. Referring to FIG. 4B, when the first to seventh contact holes (CH1 to CH7) are formed, the inorganic layers deposited on the substrate 401 located in the bending area BA may be removed together or at once. Accordingly, while the first lower buffer layer 402 and the second lower buffer layer 411 in the bending area BA are etched, the first polycrystalline semiconductor pattern 414 located on the second lower buffer layer 411 may be continuously exposed to the etching gas, and thereby, be damaged.

However, in the second embodiment, since the third conductive patterns 415 are disposed on the upper edges (e.g., upper surfaces) of the first polycrystalline semiconductor pattern 414, the first polycrystalline semiconductor pattern 414 can be prevented or at least reduced from being exposed to the etching gas while the first lower buffer layer 402 and the second lower buffer layer 411 disposed in the bending area BA are etched.

--A third embodiment--

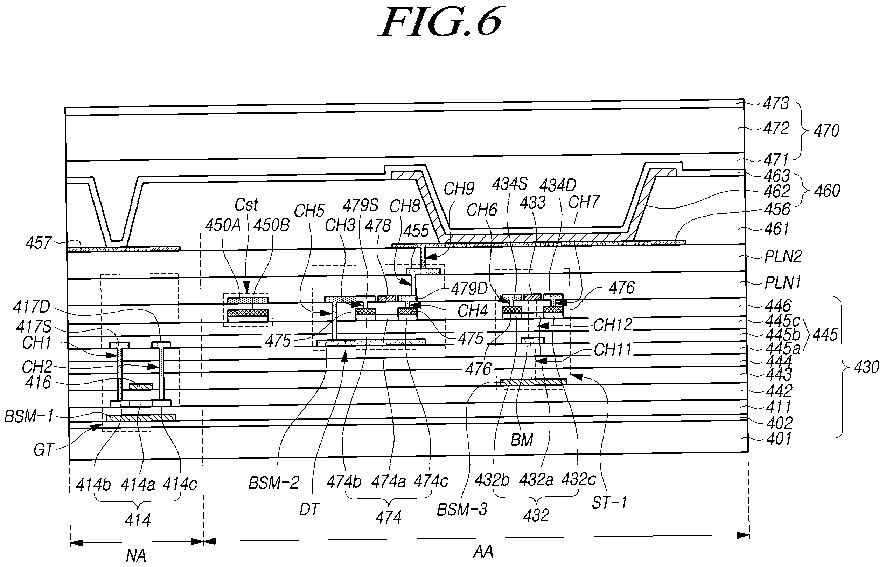

The third embodiment of the present disclosure will be described with reference to FIG. 6. The display area AA and the non-display area NA of the display device 100 according to the third embodiment may be basically based on configurations of, and have nearly the same configurations as, the display area AA and the non-display area NA of the display device 100 according to the first embodiment. Thus, considering similarity between the first and third embodiments and for convenience of description, discussions on the third embodiment will be provided only for the different configurations between the first and third embodiments.

Referring to FIG. 6, a driving thin film transistor DT disposed in a subpixel in the third embodiment may have the same configuration as that in the first embodiment. However, the configuration of a first thin film transistor GT disposed in the non-display area NA may be partly different from that of the first thin film transistor GT in the first embodiment, and the configuration of a first switching thin film transistor ST-1 may also be partly different from that of the first switching thin film transistor ST-1 in the first embodiment.

In the third embodiment, a first polycrystalline semiconductor pattern 414, a first gate electrode 416, and a first light shield pattern BSM-1 of the first thin film transistor GT may have the same configurations as those of the first thin film transistor GT in the first embodiment.

In the third embodiment, first source and drain electrodes (417S and 417D) of the first thin film transistor GT may be disposed in a lower layer than second source and drain electrodes (479S and 479D). For example, the first source and drain electrodes (417S and 417D) may be disposed on or in the same layer as the second light shield pattern BSM-2. As the first source and drain electrodes (417S and 417D) and the second light shield pattern BSM-2 are disposed on or in the same layer, the first source and drain electrodes (417S and 417D) and the second light shield pattern BSM-2 may include the same material and be formed simultaneously or together. Thus, the first source and drain electrodes (417S and 417D) and the second light shield pattern BSM-2 may formed through one mask process.

As a result, first and second contact holes (CH1 and CH2) may be formed earlier than third to seventh contact holes (CH3 to CH7).

Since the first and second contact holes (CH1 and CH2) having relatively short depths are formed, associated etching may be controlled under an optimal condition so as not to damage the first polycrystalline semiconductor pattern 414.

In an embodiment, when the first switching thin film transistor ST-1 has a dual gate, a third gate electrode 433 and a third light shield pattern BSM-3 may be electrically connected. In an embodiment, the third gate electrode 433 and the third light shield pattern BSM-3 may be connected to each other through an eleventh contact hole CH11 and a twelfth contact hole CH12.

In an embodiment, a bridge metal BM may be provided between the eleventh contact hole CH11 and the twelfth contact hole CH12. The bridge metal BM may include the same material, and be formed on or in the same layer, as the second light shield pattern BSM-2.

The eleventh contact hole CH11 formed under the bridge metal BM may be formed simultaneously or together when the first contact hole CH1 and the second contact hole CH2 are formed.

Accordingly, in the third embodiment, the first contact hole CH1, the second contact hole CH2, and the eleventh contact hole CH11 may be formed simultaneously or together. When the second light shield pattern BSM-2 is formed on a first sub-upper buffer layer 445a, the first source electrode 417S, the first drain electrode 417D, and the bridge metal BM may be formed simultaneously or together, therefore, resulting in the number of masks used being reduced.

In an embodiment, the third gate electrode 433 may be connected to the bridge metal BM through the twelfth contact hole CH12 and be connected to the third light shield pattern BSM-3 through the bridge metal BM, this enabling a dual gate to be formed.

In the third embodiment, although the first switching thin film transistor ST-1 has been discussed as being an oxide semiconductor thin film transistor having a dual gate, however, embodiments of the present disclosure are not limited thereto. In another embodiment, the first switching thin film transistor ST-1 may not have such a dual gate configuration. Thus, the configuration of the gate electrode may be optional. For example, when the first switching thin film transistor ST-1 has only one gate, the third light shield pattern BSM-3 and the bridge metal BM may be unnecessary.

In the third embodiment, the third to seventh contact holes (CH3 to CH7) and the twelfth contact hole CH12 may have different depths, but be formed simultaneously or together as the metal pattern is located under these contact holes.

--A fourth embodiment--

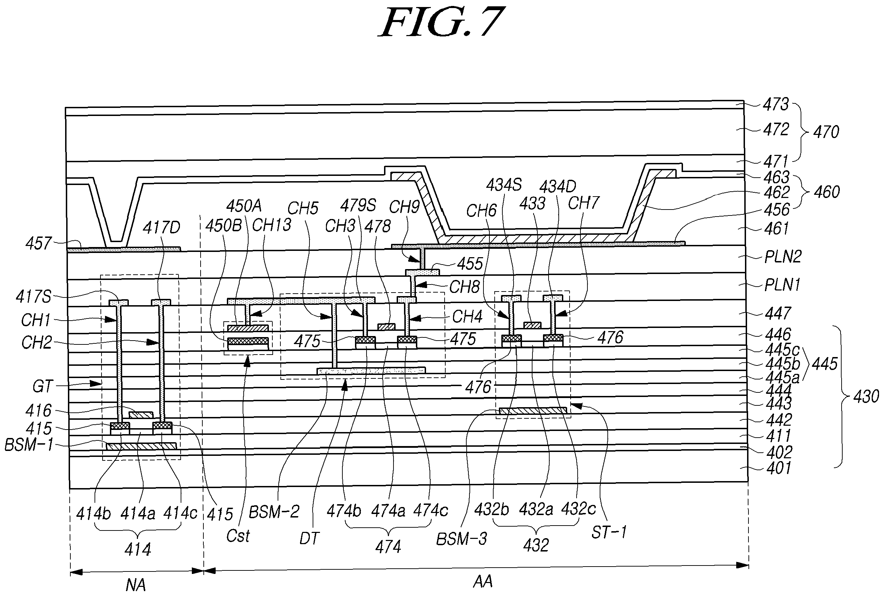

The fourth embodiment of the present disclosure will be described with reference to FIG. 7. In the fourth embodiment, a first thin film transistor GT may have nearly the same configuration as the first thin film transistor GT in the second embodiment shown in FIG. 5. However, first source and drain electrodes (417S and 417D) in the fourth embodiment may be disposed at locations different from the first source and drain electrodes (417S and 417D) in the second embodiment.

In the fourth embodiment, a driving thin film transistor DT disposed in a subpixel may have nearly the same configuration as the driving thin film transistor DT in the first embodiment. However, second source and drain electrodes (479S and 479D) in the fourth embodiment may be disposed at locations different from the second source and drain electrodes (479S and 479D) in the first embodiment.

A first switching thin film transistor ST-1 in the fourth embodiment may have nearly the same configuration as the first switching thin film transistor ST-1 in the first embodiment. However, third source and drain electrodes (434S and 434D) in the fourth embodiment may be disposed at locations different from the third source and drain electrodes (434S and 434D) in the first embodiment.

In the fourth embodiment, the first source electrode 417S, the first drain electrode 417D, the second source electrode 479S, the second drain electrode 479D, the third source electrode 434S, and the third drain electrode 434D may be disposed on or in the same layer. However, unlike the first embodiment, the first source electrode 417S, the first drain electrode 417D, the second source electrode 479S, the second drain electrode 479D, the third source electrode 434S, and the third drain electrode 434D may be disposed in a different layer from the second gate electrode 478 without being disposed on or in the same layer as the second gate electrode 478. For example, in the fourth embodiment, the first source electrode 417S, the first drain electrode 417D, the second source electrode 479S, the second drain electrode 479D, the third source electrode 434S, and the third drain electrode 434D may be disposed on a third interlayer insulating layer 447 located on the second gate electrode 478.

In the first embodiment, although the second source electrode 479S and the second drain electrode 479D may be disposed in the same layer as the second gate electrode 478, and thereby, there is provided an advantage of being formed by one mask process, a short circuit may be formed as the second source electrode 479S, the second drain electrode 479D, and the second gate electrode 478 are arranged very narrowly.

Accordingly, in the fourth embodiment, the second source electrode 479S and the second drain electrode 479D may be disposed in a different layer from the second gate electrode 478. For example, the second source electrode 479S and the second drain electrode 479D may be disposed on the third interlayer insulating layer 447 located on the second gate electrode 478. Thus, the second gate electrode 478 is closer to the substrate 401 than the second source electrode 479S and the second drain electrode 479D.

The first source electrode 417S, the first drain electrode 417D, the third source electrode 434S, and the third drain electrode 434D may be disposed on or in the same layer as the second source electrode 479S and the second drain electrode 479D, resulting in steps of mask processing being reduced.

Meanwhile, the first to seventh contact holes (CH1 to CH7) and a thirteenth contact hole CH13 formed on a first electrode 450A of a storage capacitor may be formed simultaneously or together. As metal patterns are located in respective lower edges of the first to seventh contact holes (CH1 to CH7) and the thirteenth contact hole CH13, thin layers or films located in the lower edges of these contact holes can be prevented or at least reduced from being overetched.

In an embodiment, unlike the first to third embodiments, a first switching thin film transistor ST-1 may not configured with a dual gate. Thus, the third gate electrode 433 and the third light shield pattern BSM-3 may not be electrically connected to each other. Accordingly, a process of forming a separate contact hole for connecting the third gate electrode 433 to the third light shield pattern BSM-3 may be omitted.

In an embodiment, as described above, the first switching thin film transistor ST-1 may have a dual gate. However, in the fourth embodiment, since the third gate electrode 433 and the third light shield pattern BSM-3 may not be connected to each other, a contact hole process for electrically connecting them may be omitted.

In various embodiments, an organic light emitting display device comprises: a substrate including a display area and a non-display area located outside of the display area; a first thin film transistor on the substrate, the first thin film transistor comprising a first semiconductor pattern, a first gate electrode, a first source electrode, and a first drain electrode; a second thin film transistor on the substrate, the second thin film transistor comprising a second semiconductor pattern, a second gate electrode, a second source electrode, and a second drain electrode; a conductive pattern on an upper surface of at least one of the first semiconductor pattern or the second semiconductor pattern; and a first light shield pattern overlapping the second semiconductor pattern, the first light shield pattern connected to the second source electrode, wherein the first semiconductor pattern comprises a polycrystalline semiconductor pattern and the second semiconductor pattern comprises an oxide semiconductor pattern.

In one or more embodiments, the first thin film transistor is in the non-display area and the second thin film transistor is in the display area.

In one or more embodiments, the first gate electrode and the second gate electrode are in different layers, and the first gate electrode and the second gate electrode are respectively over the first semiconductor pattern and the second semiconductor pattern.

In one or more embodiments, the first semiconductor pattern comprises a first channel region, a first source region, and a first drain region such that the first channel region is interposed between the first source region and the first drain region, wherein the second semiconductor pattern comprises a second channel region, a second source region, and a second drain region such that the second channel region is interposed between the second source region and the second drain region, and wherein the conductive pattern is on upper surfaces of at least one of the first source region and the first drain regions, and the second source region and the second drain region.

In one or more embodiments, the conductive pattern is a metal pattern contacting at least one of the first semiconductor pattern and the second semiconductor pattern.

In one or more embodiments, the first light shield pattern is under the second semiconductor pattern such that the first light shield pattern is closer to the substrate than the second semiconductor pattern.

In one or more embodiments, the organic light emitting display device further comprises: a third thin film transistor in the display area, the third thin film transistor comprising a third semiconductor pattern including an oxide semiconductor pattern, a third gate electrode, a third source electrode, and a third drain electrode; and a second light shield pattern overlapping the third semiconductor pattern, wherein a vertical distance between the second semiconductor pattern and the first light shield pattern is less than a vertical distance between the third semiconductor pattern and the second light shield pattern.

In one or more embodiments, the second thin film transistor is a driving thin film transistor in a pixel and the driving thin film transistor is configured to drive a light emitting element included in the pixel, and the third thin film transistor is a switching thin film transistor in the pixel and the third thin film transistor is connected to the second thin film transistor.

In one or more embodiments, the organic light emitting display device further comprises: a lower buffer layer between the substrate and the first semiconductor pattern; and an upper buffer layer between the first semiconductor pattern and the second semiconductor pattern, wherein the first light shield pattern is inside of the upper buffer layer.

In one or more embodiments, the first source electrode, the first drain electrode, the second gate electrode, the second source electrode, and the second drain electrode are in a same layer.

In one or more embodiments, the first source electrode and the first drain electrode are on a different layer from the second source electrode and the second drain electrode where at least one insulating layer is interposed between the first source electrode and the first drain electrode and the second source electrode and the second drain electrode.

In one or more embodiments, the first source electrode, the first drain electrode, the second source electrode, and the second drain electrode are in a same layer, and the second gate electrode is between the second semiconductor pattern and the second source electrode.

In one or more embodiments, the first source electrode and the first drain electrode are over the first gate electrode such that at least one insulating layer is interposed between the first gate electrode and the first source electrode and the first drain electrode, and the first source electrode and the first drain electrode are in a same layer as the first light shield pattern.

In one or more embodiments, the conductive pattern is on upper edges of the second source region and the second drain region.

In one or more embodiments, the conductive pattern is on upper edges of the first source region and the first drain region, and the conductive pattern is further on upper edges of the second source region and the second drain region.

In one or more embodiments, at least one of the first source region and the first drain region and the second source region and the second drain region comprise an intrinsic semiconductor pattern.

In various embodiments, an organic light emitting display device comprises: a substrate on which a display area and a non-display area located outside of the display area are disposed; a first thin film transistor disposed in the display area, and comprising a first semiconductor pattern comprising a first conductive pattern, a first gate electrode, a first source electrode, and a first drain electrode; a second thin film transistor disposed in the display area, and comprising a second semiconductor pattern comprising a second conductive pattern, a second gate electrode, and a second source electrode, and a second drain electrode; a first light shield pattern located under, and overlapping, the first semiconductor pattern such that the first light shield pattern is closer to the substrate than the first semiconductor pattern; and a second light shield pattern overlapping the second semiconductor pattern, wherein a vertical distance between the first semiconductor pattern and the first light shield pattern is less than a vertical distance between the second semiconductor pattern and the second light shield pattern.

In one or more embodiments, the first conductive pattern and the second conductive pattern each are on respective upper surfaces of the first semiconductor pattern and the second semiconductor pattern.

In one or more embodiments, the first semiconductor pattern and the second semiconductor pattern each comprise an oxide semiconductor pattern.

In one or more embodiments, the first light shield pattern is connected to the first source electrode.

In one or more embodiments, the first gate electrode, the first source electrode, the first drain electrode, the second gate electrode, the second source electrode, and the second drain electrode are in a same layer.

In one or more embodiments, the organic light emitting display device further comprises: a storage capacitor comprising one electrode in a same layer as the first semiconductor pattern and the first conductive pattern.

In one or more embodiments, the first semiconductor pattern comprises a first channel region, a first source region, and a first drain region such that the first channel region is interposed between the first source region and the first drain region, wherein the second semiconductor pattern comprises a second channel region, a second source region, and a second drain region such that the second channel region is interposed between the second source region and the second drain region, and wherein the first conductive pattern is on upper surfaces of the first source region and the first drain region, and the second conductive pattern is on upper surfaces of the second source region and the second drain region.

In one or more embodiments, the first source region and the first drain region and the second source region and the second drain region are intrinsic semiconductor patterns in which an impurity ion is not doped.

In various embodiments, a light emitting display device comprises: a substrate including a display area and a non-display area around the display area; a first thin film transistor in the display area, the first thin film transistor including a first drain electrode, a first source electrode, a first gate electrode, and a first semiconductor pattern having a first channel region, a first source region at a first end of the first channel region, and a first drain region at a second end of the first channel region that is opposite the first end; a first conductive pattern on the first semiconductor pattern, the first conductive pattern including a first conductive portion that is in contact with and overlaps an upper surface of the first source region and a second conductive portion that is in contact with and overlaps an upper surface of the first drain region; and a light emitting element configured to emit light, the light emitting element connected to the first thin film transistor.

In one or more embodiments, the first conductive pattern is non-overlapping with the first channel region and is not in contact with the first channel region.

In one or more embodiments, the first source electrode is in contact with the first conducive portion and the first drain electrode is in contact with the second conductive portion.

In one or more embodiments, the light emitting display device further comprises: a second thin film transistor in the display area, the second thin film transistor including a second drain electrode, a second source electrode, a second gate electrode, and a second semiconductor pattern having a second channel region, a second source region at a first end of the second channel region, and a second drain region at a second end of the second channel region that is opposite the first end of the second channel region; and a third thin film transistor in the non-display area, the third thin film transistor including a third drain electrode, a third source electrode, a third gate electrode, and a third semiconductor pattern having a third channel region, a third source region at a first end of the third channel region, and a third drain region at a second end of the third channel region that is opposite the first end of the third channel region, wherein the first semiconductor pattern and the second semiconductor pattern comprise oxide and the third semiconductor pattern comprises polycrystalline.

In one or more embodiments, the first drain electrode, the first source electrode, the second drain electrode, the second source electrode, the third drain electrode, and the third source electrode are on a same layer.

In one or more embodiments, the light emitting display device further comprises: a second conductive pattern on the second semiconductor pattern, the second conductive pattern including a first conductive portion that is in contact with and overlaps an upper surface of the second source region and a second conductive portion that is in contact with and overlaps an upper surface of the second drain region; and a third conductive pattern on the third semiconductor pattern, the third conductive pattern including a first conductive portion that is in contact with and overlaps an upper surface of the third source region and a second conductive portion that is in contact with and overlaps an upper surface of the third drain region.

In one or more embodiments, the first gate electrode is closer to the substrate than the first drain electrode and the first source electrode.

In one or more embodiments, the first drain electrode, the first source electrode, the second drain electrode, and the second source electrode are on a different layer from the third source electrode and the third drain electrode such that the third source electrode and the third drain electrode are closer to the substrate than the first drain electrode, the first source electrode, the second drain electrode, and the second source electrode.

In one or more embodiments, the light emitting display device further comprises: a second conductive pattern on the second semiconductor pattern, the second conductive pattern including a first conductive portion that is in contact with and overlaps an upper surface of the second source region and a second conductive portion that is in contact with and overlaps the second drain region.

In one or more embodiments, the light emitting display device further comprises: a first light shield layer that overlaps the first thin film transistor; and a second light shield layer that overlaps the second thin film transistor, wherein a first vertical distance between the first light shield layer to the first semiconductor pattern is less than a second vertical distance between the second light shield layer and the second semiconductor pattern.

The discussions given above and accompanying drawings are merely exemplary in nature and are not intended to limit the disclosure or its application. It could be noted that various modifications and variations such as combination, separation, substitution, and changes of configurations in the described examples and embodiments will be readily apparent to those skilled in the art, without departing from the scope of the embodiments and examples of present disclosure. Although the exemplary embodiments have been described for illustrative purposes, a person skilled in the art will appreciate that various modifications and applications are possible without departing from the essential characteristics of the present disclosure. For example, the specific components of the exemplary embodiments may be variously modified.

**Claims**

1. An organic light emitting display device (100) comprising:

   a substrate (401) including a display area (AA) and a non-display area (NA) located outside of the display area (AA);
   a first thin film transistor (GT) on the substrate (401), the first thin film transistor (GT) comprising a first semiconductor pattern (414), a first gate electrode (416), a first source electrode (417S), and a first drain electrode (417D);
   a second thin film transistor (DT) on the substrate (401), the second thin film transistor (DT) comprising a second semiconductor pattern (474), a second gate electrode (478), a second source electrode (479S), and a second drain electrode (479D);
   a conductive pattern (415, 475) on an upper surface of at least one of the first semiconductor pattern (414) or the second semiconductor pattern (474); and
   a first light shield pattern (BSM-2) overlapping the second semiconductor pattern (474), the first light shield pattern (BSM-2) connected to the second source electrode (479S),
   wherein the first semiconductor pattern (414) comprises a polycrystalline semiconductor pattern and the second semiconductor pattern (474) comprises an oxide semiconductor pattern.

2. The organic light emitting display device (100) according to claim 1, wherein the first thin film transistor (GT) is in the non-display area (NA) and the second thin film transistor (DT) is in the display area (AA).

3. The organic light emitting display device (100) according to claim 1 or 2, wherein the first gate electrode (416) and the second gate electrode (478) are in different layers, and the first gate electrode (416) and the second gate electrode (478) are respectively over the first semiconductor pattern (414) and the second semiconductor pattern (474).

4. The organic light emitting display device (100) according to any of claims 1 to 3, wherein the first semiconductor pattern (414) comprises a first channel region (414a), a first source region (414b), and a first drain region (414c) such that the first channel region (414a) is interposed between the first source region (414b) and the first drain region (414c),

   wherein the second semiconductor pattern (474) comprises a second channel region (474a), a second source region (474b), and a second drain region (474c) such that the second channel region (474a) is interposed between the second source region (474b) and the second drain region (474c), and
   wherein the conductive pattern (415, 475) is on upper surfaces of at least one of the first source region (414b) and the first drain region (414c), and the second source region (474b) and the second drain region (474c),
   wherein, preferably, the conductive pattern (415, 475) is a metal pattern contacting at least one of the first semiconductor pattern (414) and the second semiconductor pattern (474).

5. The organic light emitting display device (100) according to claim 4, wherein the conductive pattern (475) is on upper edges of the second source region (474b) and the second drain region (474c).

6. The organic light emitting display device (100) according to claim 5, wherein the conductive pattern (415, 475) is further on upper edges of the first source region (414b) and the first drain region (414c).

7. The organic light emitting display device (100) according to any of claims 4 to 6, wherein at least one of the first source region (414b) and the first drain region (414c) and the second source region (474b) and the second drain region (474c) comprise an intrinsic semiconductor pattern.

8. The organic light emitting display device (100) according to any of claims 1 to 7, wherein the first light shield pattern (BSM-2) is under the second semiconductor pattern (474) such that the first light shield pattern (BSM-2) is closer to the substrate (401) than the second semiconductor pattern (474).

9. The organic light emitting display device (100) according to claim 8, further comprising:

a third thin film transistor (ST-1) in the display area (AA), the third thin film transistor (ST-1) comprising a third semiconductor pattern (432) including an oxide semiconductor pattern, a third gate electrode (433), a third source electrode (434S), and a third drain electrode (434D); and
a second light shield pattern (BSM-3) overlapping the third semiconductor pattern (432),
wherein a vertical distance between the second semiconductor pattern (474) and the first light shield pattern (BSM-2) is less than a vertical distance between the third semiconductor pattern (432) and the second light shield pattern (BSM-3).

10. The organic light emitting display device (100) according to claim 9, wherein the second thin film transistor (DT) is a driving thin film transistor (DT) in a pixel and the driving thin film transistor (DT) is configured to drive a light emitting element (460) included in the pixel, and the third thin film transistor (ST-1) is a switching thin film transistor (ST-1) in the pixel and the third thin film transistor (ST-1) is connected to the second thin film transistor (DT).

11. The organic light emitting display device (100) according to any of claims 1 to 10, further comprising:

a lower buffer layer (402, 411) between the substrate (401) and the first semiconductor pattern (414); and
an upper buffer layer (445) between the first semiconductor pattern (414) and the second semiconductor pattern (474), wherein the first light shield pattern (BSM-2) is inside of the upper buffer layer (445).

12. The organic light emitting display device (100) according to any of claims 1 to 11, wherein the first source electrode (417S), the first drain electrode (417D), the second gate electrode (478), the second source electrode (479S), and the second drain electrode (479D) are in a same layer.

13. The organic light emitting display device (100) according to any of claims 1 to 11, wherein the first source electrode (417S) and the first drain electrode (417D) are on a different layer from the second source electrode (479S) and the second drain electrode (479D) where at least one insulating layer (446) is interposed between the first source electrode (417S) and the first drain electrode (417D) and the second source electrode (479S) and the second drain electrode (479D).

14. The organic light emitting display device (100) according to any of claims 1 to 11, wherein the first source electrode (417S), the first drain electrode (417D), the second source electrode (479S), and the second drain electrode (479D) are in a same layer, and the second gate electrode (478) is between the second semiconductor pattern (474) and the second source electrode (479S).

15. The organic light emitting display device (100) according to claim 13, wherein the first source electrode (417S) and the first drain electrode (417D) are over the first gate electrode (416) such that at least one insulating layer (443, 444) is interposed between the first gate electrode (416) and the first source electrode (417S) and the first drain electrode (417D), and the first source electrode (417S) and the first drain electrode (417D) are in a same layer as the first light shield pattern (BSM-2).

# FIG.1A

# *FIG.1B*

# FIG.2

# FIG.3

## FIG.4A

# FIG.4B

# FIG.5

FIG.6

FIG.7

EP 4 262 337 A1

Europäisches
Patentamt

European
Patent Office

Office européen
des brevets

# EUROPEAN SEARCH REPORT

Application Number

**EP 23 16 5480**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 4 156 274 A1 (LG DISPLAY CO LTD [KR]) 29 March 2023 (2023-03-29) * paragraphs [0011] – [0013], [0053] – [0055], [0080], [0095], [0100], [0104]; claim 1; figure 3 * ----- | 1-5, 8-11,14 | INV. H10K59/126 H01L29/786 |
| X | US 2020/402467 A1 (CHOI HYE LIM [KR] ET AL) 24 December 2020 (2020-12-24) * paragraphs [0003], [0004], [0064] – [0067], [0157] – [0160]; figures 1,21 * | 1-5,8, 11,13 | |
| Y | | 1-4,8, 11,13-15 | |
| A | | 6,7,9, 10,12 | |
| Y | US 2019/006521 A1 (NOH SOYOUNG [KR] ET AL) 3 January 2019 (2019-01-03) * paragraphs [0003] – [0006], [0039] – [0061], [0087]; figures 1,5 * ----- | 1-4,8, 11,13-15 | |
| | | | TECHNICAL FIELDS SEARCHED (IPC) H10K H01L |

The present search report has been drawn up for all claims

| Place of search | Date of completion of the search | Examiner |
|---|---|---|
| The Hague | 4 September 2023 | Welter, Steve |

EPO FORM 1503 03.82 (P04C01)

## EP 4 262 337 A1

### ANNEX TO THE EUROPEAN SEARCH REPORT
### ON EUROPEAN PATENT APPLICATION NO.

EP 23 16 5480

04-09-2023

| Patent document cited in search report | Publication date | Patent family member(s) | | Publication date |
|---|---|---|---|---|
| EP 4156274 A1 | 29-03-2023 | CN | 115942803 A | 07-04-2023 |
| | | EP | 4156274 A1 | 29-03-2023 |
| | | JP | 2023035999 A | 13-03-2023 |
| | | KR | 20230032132 A | 07-03-2023 |
| | | US | 2023065335 A1 | 02-03-2023 |
| US 2020402467 A1 | 24-12-2020 | CN | 112117309 A | 22-12-2020 |
| | | KR | 20200145882 A | 31-12-2020 |
| | | US | 2020402467 A1 | 24-12-2020 |
| US 2019006521 A1 | 03-01-2019 | CN | 109216374 A | 15-01-2019 |
| | | CN | 115810634 A | 17-03-2023 |
| | | KR | 20190003150 A | 09-01-2019 |
| | | KR | 20230050291 A | 14-04-2023 |
| | | US | 2019006521 A1 | 03-01-2019 |
| | | US | 2020058797 A1 | 20-02-2020 |
| | | US | 2022199835 A1 | 23-06-2022 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• KR 1020220047164